# EUROPÄISCHE PATENTANMELDUNG

(11) **EP 3 723 217 A1**
(43) Veröffentlichungstag der Anmeldung: **14.10.2020**
(21) Anmeldenummer: 19168385.3
(22) Anmeldetag: 10.04.2019
(51) Int. Cl.: H02H 1/00, G01R 19/10, H02H 3/08, H02H 3/04

(54) **SCHUTZEINRICHTUNG ZUM ABSCHALTEN EINES ÜBERSTROMS IN EINEM GLEICHSPANNUNGSNETZ**

(71) Anmelder: Siemens Aktiengesellschaft, 80333 München (DE)
(72) Erfinder: Föcking, Bernhard, 91058 Erlangen (DE); Weis, Benno, 91334 Hemhofen (DE)

(57) **Zusammenfassung**

Die Erfindung betrifft eine Schutzeinrichtung (1) zum Abschalten eines Überstroms in einem Gleichspannungsnetz. Diese umfasst ein steuerbares Halbleiterschaltelement (5) und eine Schmelzsicherung (8), die in einer zu überwachenden Leitung in Reihe miteinander verschaltet sind. Eine Treiberschaltung (6) schaltet beim Erhalt eines Triggersignals (s_{Tr}) das steuerbare Halbleiterschaltelement (5) sperrend. Eine Auswerteeinheit (7) zur Erzeugung des Triggersignals (s_{Tr}) ist dazu eingerichtet, einen Spannungsabfall (U₈) über der Schmelzsicherung (8) zu ermitteln und basierend auf einem Ergebnis einer Auswertung des Spannungsabfalls (U₈) das Triggersignal (s_{Tr}) zu erzeugen.

## Beschreibung

Die Erfindung betrifft eine Schutzeinrichtung zum Abschalten eines Überstroms in einem Gleichspannungsnetz.

Gleichspannungsnetze umfassen häufig eine Mehrzahl von Teilnetzen, an die verschiedene elektrische Komponenten angeschlossen sind. Häufig sind in den verschiedenen Teilnetzen Kondensatoren angeordnet. Die in den Kondensatoren gespeicherten Ladungen führen im Falle eines durch einen Fehler hervorgerufenen Kurschlusses in einem der Teilnetze dazu, dass der prospektive Kurschlussstrom sehr schnell auf unzulässig hohe Werte ansteigt, was zu Schädigungen der an die Teilnetze angeschlossenen Komponenten führen kann. Um dies zu verhindern, sind unterschiedliche Teilnetze über Schutzeinrichtungen zum Abschalten eines Überstroms verbunden. Die notwendige Erkennung eines unzulässig hohen Stromes (sogenannter Überstrom) erfordert Stromsensoren, die teuer sind.

Es ist bekannt, für den Kurzschlussschutz in Gleichspannungsnetzen schnell reagierende Schmelzsicherungen zu verwenden. Diese werden auch als Halbleitersicherungen bezeichnet. Ein Nachteil von Schmelzsicherungen besteht darin, dass diese einen hohen Peak-Strom aufweisen und nach einer Auslösung ein Austausch erforderlich ist. Ein weiteres Problem besteht darin, dass Schmelzsicherungen nicht schnell genug reagieren, um zu verhindern, dass in dem durch die Schutzeinrichtungen verbundenen Gleichspannungs-Teilnetzen die Netzspannung einbricht, so dass nicht von dem Fehler betroffenen Teilnetze einer Unterspannung ausgesetzt sind.

Ferner bekannt sind elektronische Kurzschlussschutzeinrichtungen, die auch als Smart Fuses bezeichnet werden. Diese können Fehlerströme mittels steuerbarer Leistungshalbleiterschaltern sehr schnell begrenzen und abschalten. Eine Stromerfassung erfolgt hier üblicherweise über einen Messwiderstand in Gestalt eines Shunts, der jedoch mit hohen Kosten verbunden ist. Im Vergleich zu Schmelzsicherungen weisen elektronische Kurzschlussschutzeinrichtungen eine höhere Ausfallswahrscheinlichkeit (sogenannte FIT-Rate) auf.

Um das Problem der Ausfallsicherheit von elektronischen Kurzschlussschutzeinrichtungen zu reduzieren, werden bislang Schmelzsicherungen und elektronische Schutzeinrichtung in Reihe geschaltet. Hierbei übernimmt die elektronische Kurzschlusseinrichtung die eigentliche Schutzfunktion, während die Schmelzsicherung nur im Falle des Versagens der elektronischen Kurzschlussschutzeinrichtung ansprechen soll. Ein Nachteil dieser Kombination besteht in den hohen Kosten, die durch die in der elektronischen Kurzschlussschutzeinrichtung vorhandene Strommesseinrichtung bedingt sind.

Es ist Aufgabe der Erfindung, eine Schutzeinrichtung anzugeben, die baulich und/oder funktionell dahingehend verbessert ist, dass sie bei geringeren Kosten eine mindestens gleichwertige Schutzfähigkeit wie existierende Schutzeinri201828094_Anmeldchtungen aufweist.

Diese Aufgabe wird gelöst durch eine Schutzeinrichtung gemäß den Merkmalen des Anspruchs 1. Vorteilhafte Ausgestaltungen ergeben sich aus den abhängigen Ansprüchen.

Es wird eine Schutzeinrichtung zum Abschalten eines Überstroms in einem Gleichspannungsnetz vorgeschlagen. Die Schutzeinrichtung umfasst ein steuerbares Halbleiterschaltelement und eine Schmelzsicherung, die in einer zu überwachenden Leitung in Reihe miteinander verschaltet sind. Die zu überwachende Leitung verbindet zum Beispiel ein erstes und ein zweites Gleichspannungs-Teilnetz, an die unterschiedliche Komponenten, insbesondere auch Kondensatoren, angeschlossen sind. Die Schutzeinrichtung umfasst ferner eine Treiberschaltung, die beim Erhalt eines Triggersignals das steuerbare Halbleiterschaltelement sperrend schaltet. Weiter ist eine Auswerteeinheit zur Erzeugung des Triggersignals vorgesehen. Die Auswerteeinheit ist dazu eingerichtet, einen Spannungsabfall über der Schmelzsicherung zu ermitteln und basierend auf einem Ergebnis einer Auswertung des Spannungsabfalls das Triggersignal zu erzeugen.

Die erfindungsgemäße Schutzeinrichtung basiert, wie dies bei aus dem Stand der Technik bekannten Schutzeinrichtungen vorgesehen ist, auf der Serienschaltung eines steuerbaren Halbleiterschaltelements und einer Schmelzsicherung. Im Unterschied zu der aus dem Stand der Technik bekannten Anordnung benötigt das steuerbare Halbleiterschaltelement jedoch keinen internen Messwiderstand. Stattdessen wird ein über der Schmelzsicherung anfallender Spanungsabfall durch die Auswerteeinheit ermittelt und ausgewertet, um basierend hierauf das Triggersignal zum Abschalten des steuerbaren Halbleiterschaltelements zu erzeugen.

Durch den Entfall des teuren, internen Messwiderstands ergeben sich eine Verringerung von Kosten, Bauraum und Verlustleistung. Da die Schmelzsicherung aus Gründen der Ausfallsicherheit ohnehin vorgesehen wird, entsteht bei der vorgeschlagenen Schutzeinrichtung kein Zusatzaufwand, da von Haus aus erforderliche Bauelemente zur Realisierung der Schutzfunktion genutzt werden.

Ein weiterer Vorteil besteht darin, dass sich die Betriebssicherheit erhöht, da der Spannungsabfall über der Schmelzsicherung aufgrund des starken positiven Temperaturkoeffizienten des Schmelzleitermaterials bei hohem Strom überproportional stark zunimmt. Im Gegensatz dazu ist bei als Messwiderständen eingesetzten handelsüblichen Shunts der Temperaturkoeffizient absichtlich sehr klein, um eine hohe Messgenauigkeit erzielen zu können. Im Fall des Kurzschlussschutzes ist jedoch keine hohe Genauigkeit erforderlich, so dass das kostengünstige Material der Schmelzsicherung mit hohem Temperaturkoeffizienten vorteilhaft genutzt werden kann. Die Verluste im Normalbetrieb sind dabei klein, während bei hohem Strom ein verhältnismäßig großes Signal aufgrund des hohen Spannungsabfalls ausgewertet werden kann, wodurch die Betriebssicherheit erhöht wird.

Zusätzlich berücksichtigt der Spannungsabfall über der Schmelzsicherung intrinsische Betriebsbedingungen der Sicherung, wie zum Beispiel eine temperaturbedingte Widerstandsänderung, die abhängig von der Strombelastung ist. Auch dies führt unter ungünstigen, weil warmen, Betriebsbedingungen zu einem zusätzlich schnelleren Ansteigen der durch die Auswerteeinheit zu detektierenden Spannung über der Schmelzsicherung.

Zudem können dynamische Widerstandsänderungen durch Skin- und Proximity-Effekte genutzt werden, was ebenfalls zu hohen Stromanstiegsgeschwindigkeiten im Kurzschlussfall führt. Dieser Effekt resultiert daraus, dass die Schmelzsicherung einen Induktivitäts-Anteil umfasst, welcher sich in einem schnelleren Ansprechen, das heißt in einer schnelleren Spannungsänderung, beim Ansteigen eines Stromes bemerkbar macht. Dies kann z.B. als Hinweis ausgewertet werden, dass Probleme in einem der durch die Schutzeinrichtung verbundenen Gleichspannungs-Teilnetze vorliegen.

Ein weiterer Vorteil der vorgeschlagenen Schutzeinrichtung besteht darin, dass ein verringerter Verdrahtungsaufwand bei der Installation besteht, da die Schmelzsicherung aufgrund der hohen Betriebssicherheit fest in der Schutzeinrichtung verbaut werden kann.

Gemäß einer zweckmäßigen Ausgestaltung ist die Auswerteeinheit dazu eingerichtet, den ermittelten Spannungsabfall mit einem vorgegebenen Spannungsgrenzwert zu vergleichen und beim Überschreiten des Grenzwerts das Triggersignal zu erzeugen.

Das Triggersignal, das der Treiberschaltung zugeführt wird, wird dann durch die Treiberschaltung verarbeitet, um ein entsprechendes Ansteuersignal für das steuerbare Halbleiterschaltelement zu erzeugen, um dieses in einen sperrenden Zustand zu verbringen. Da ein Fehlerstrom in einem Gleichspannungsnetz (DC-Netz) in beide Richtungen fließen kann, wird in einer vorteilhaften Ausgestaltung der Betrag des ermittelten Spannungsabfalls mit einem vorgegebenen Spannungsgrenzwert verglichen. Alternativ wird das Triggersignal dann gesetzt, wenn der ermittelte Spannungsabfall entweder oberhalb eines ersten positiven Spannungsgrenzwerts oder unterhalb eines zweiten negativen Spannungsgrenzwerts liegt.

Eine weitere zweckmäßige Ausgestaltung sieht vor, dass in der zu überwachenden Leitung zusätzlich ein Shunt, d.h. ein Messwiderstand, angeordnet ist, der in Reihe zu dem steuerbaren Halbleiterschaltelement und der Schmelzsicherung liegt. Insbesondere ist es zweckmäßig, wenn der Shunt zwischen dem steuerbaren Halbleiterschaltelement und der Schmelzsicherung angeordnet ist. Hierdurch ist es möglich, eine handelsübliche elektronische Kurzschlussschutzeinrichtung (Smart Fuse) zu verwenden, welche dem Shunt als Messwiderstand zum Ansteuern des steuerbaren Halbleiterschaltelements nutzt.

Insbesondere ist es in dieser Ausgestaltung vorgesehen, dass die Auswerteeinheit dazu eingerichtet ist, zusätzlich zu dem Spannungsabfall über der Schmelzsicherung einen Spannungsabfall über dem Shunt zu ermitteln. Hierdurch kann in redundanter Weise ein Stromanstieg in der zu überwachenden Leitung detektiert werden. Dadurch kann die Ausfallsicherheit der vorgeschlagenen Schutzeinrichtung weiter erhöht werden. Zudem ist es möglich, handelsübliche Bauteile zu verwenden. Hierdurch können Skaleneffekte zur Reduzierung der Kosten zur Bereitstellung der Schutzeinrichtung vorteilhaft genutzt werden.

Eine weitere zweckmäßige Ausgestaltung sieht vor, dass die Auswerteeinheit dazu eingerichtet ist, aus dem Spannungsabfall über dem Shunt den durch die Leitung fließenden Strom zu ermitteln und basierend auf dem ermittelten Strom und dem ermittelten Spannungsabfall über der Schmelzsicherung einen Vitalparameter der Schmelzsicherung zu ermitteln. Durch die Ermittlung des in der zu überwachenden Leitung fließenden Stroms ist es somit zur weiteren Erhöhung der Ausfallsicherheit möglich, die Funktionsfähigkeit der Schmelzsicherung zu überwachen und als Vitalparameter bereitzustellen.

Es kann insbesondere vorgesehen sein, dass die Auswerteinheit dazu eingerichtet ist, aus dem Strom und einem initialen Widerstandswert der Schmelzsicherung einen theoretischen Spannungsabfall über der Schmelzsicherung zu ermitteln und aus einem Vergleich des theoretischen Spannungsabfalls mit dem gemessenen Spannungsabfall den Vitalparameter zu bestimmen. Alternativ oder zusätzlich kann vorgesehen sein, dass die Auswerteeinheit dazu eingerichtet ist, aus dem Strom und dem gemessenen Spannungsabfall einen Widerstandswert der Schmelzsicherung zu ermitteln und aus einem Vergleich des ermittelten Widerstandswerts mit einem für den gemessenen Strom vorab bestimmten initialen Widerstandswert den Vitalparameter zu bestimmen.

Beide Varianten basieren darauf, aus dem durch den Shunt ermittelten Strom auf den Spannungsabfall in der Schmelzsicherung zu schließen und mit einem initialen Wert zu vergleichen. Hierdurch können beispielsweise Alterungseffekte der Schmelzsicherung detektiert werden. Falls beispielsweise festgestellt wird, dass der Widerstandswert der Schmelzsicherung im Laufe der Zeit ansteigt, ist dies ein Hinweis darauf, dass die Schmelzsicherung alterungsbedingte Effekte aufweist. Hierdurch kann beispielsweise ein in Kürze notwendiger oder sinnvoller Wechsel der Schmelzsicherung angezeigt werden. Die Widerstandsbewertung kann beispielsweise auf einem Vergleich mit einem früheren, initial erfassten Widerstandswert basieren.

Es wird somit die Alterung der Schmelzsicherung erkannt, indem ein Vergleich der Spannungsabfälle über der Schmelzsicherung und über dem Shunt vorgenommen wird. Dies ermöglicht eine prädiktive Wartung. Ein Nutzer der Schutzeinrichtung kann über den Alterungszustand der Schmelzsicherung informiert und in die Lage versetzt werden, die betroffene Schmelzsicherung vor Eintritt eines Schadenfalls auszutauschen. Hierzu kann beispielsweise durch die Auswerteeinrichtung ein entsprechendes Indikatorsignal, zum Beispiel eine Warnleuchte oder eine andere elektronische Information, wie zum Beispiel eine E-Mail, erzeugt werden. Letzteres ermöglicht die Übertragung einer Information über einen "Verschleißzustand" an Cloudbasierte Systeme.

Die Erfindung wird nachfolgend näher anhand von Ausführungsbeispielen in der Zeichnung erläutert. Es zeigen:
- Fig. 1: ein erstes Ausführungsbeispiel einer erfindungsgemäßen Schutzeinrichtung; und
- Fig. 2: ein zweites Ausführungsbeispiel einer erfindungsgemäßen Schutzeinrichtung zum Abschalten eines Überstroms.

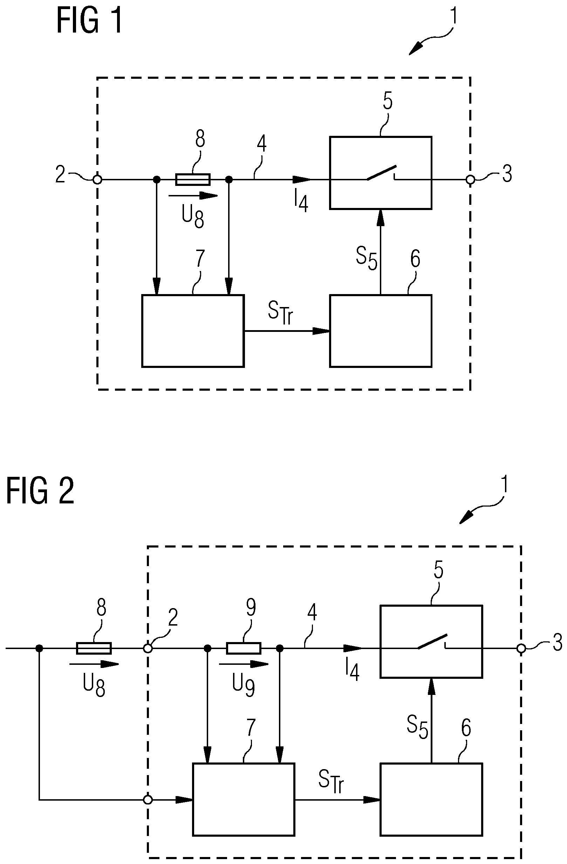

In den Figuren 1 und 2 sind zwei unterschiedliche Schutzeinrichtungen zum Abschalten eines Überstroms in einem Gleichspannungsnetz dargestellt. Die Schutzeinrichtungen 1 sind in einer zu überwachenden Leitung angeordnet und verbinden ein erstes und ein zweites Gleichspannungs-Teilnetz, welche der Übersichtlichkeit halber nicht dargestellt sind. Das erste Gleichspannungs-Teilnetz ist an eine erste Klemme 2 der Schutzeinrichtung 1 angeschlossen. Das zweite Gleichspannungs-Teilnetz ist an eine zweite Klemme 3 der Schutzeinrichtung 1 angeschlossen. In bekannter Weise umfassen das erste und das zweite Gleichspannungs-Teilnetz Energieerzeuger und/oder -verbraucher und/oder -speicher. Insbesondere umfassen das erste und das zweite Gleichspannungs-Teilnetz Kondensatoren als Energiespeicher.

Die Schutzeinrichtung 1 des Ausführungsbeispiels gemäß Fig. 1 umfasst zwischen der ersten und der zweiten Klemme 2, 3 eine Serienschaltung aus einem steuerbaren Halbleiterschaltelement 5 und einer Schmelzsicherung 8. Die Serienschaltung des steuerbaren Halbleiterschaltelements 5 und der Schmelzsicherung ist in der zu überwachenden Leitung 4 verschaltet. Das steuerbare Halbleiterschaltelement 5 ist beispielsweise ein MOSFET (Metall-Oxid-Feldeffekttransistor) oder ein IGBT (Insulated Gate Bipolar Transistor). Grundsätzlich kann das steuerbare Halbleiterschaltelement auch von einem anderen Typ sein.

Eine Treiberschaltung 6 dient dazu, beim Erhalt eines Triggersignals s_{Tr} das steuerbare Halbleiterschaltelement 5 sperrend zu schalten. Das Triggersignal s_{Tr} wird von einer Auswerteeinheit 7 bereitgestellt, wobei die Auswerteeinheit 7 dazu eingerichtet ist, eine über der Schmelzsicherung 8 abfallende Spannung U₈ zu ermitteln. Basierend auf einem Ergebnis einer Auswertung des Spannungsabfalls U₈ wird dann das Triggersignal s_{Tr} erzeugt. Insbesondere wird hierzu durch die Auswerteeinheit 7 der ermittelte Spannungsabfall U₈ mit einem vorgegebenen Spannungsgrenzwert, der vorab ermittelt wurde und in einem Speicher der Auswerteeinheit 7 hinterlegt ist, verglichen. Überschreitet der Spannungsabfall U₈ den vorab definierten Spannungsgrenzwert, so wird das Triggersignal s_{Tr} erzeugt. Infolgedessen erzeugt die Treiberschaltung 6 ein Ansteuersignal s₅, durch das das steuerbare Halbleiterschaltelement 5 sperrend geschaltet wird.

Die Schmelzsicherung 8 weist insbesondere einen stark positiven Temperaturkoeffizienten auf. Dieser kann beispielsweise durch die Nutzung von Kupfer als Schmelzleitermaterial bereitgestellt werden. Hierdurch fällt über der Schmelzsicherung 8 bei einem über die Leitung 4 fließenden Überstrom I₄ eine hohe Spannung ab, wodurch in der Auswerteeinheit 7 der festgelegte Spannungsgrenzwert in kurzer Zeit überschritten und das Triggersignal s_{Tr} erzeugt wird. Infolgedessen erfolgt beim Auftreten eines Überstroms eine schnelle Abschaltung des steuerbaren Halbleiterschaltelements 5.

Durch die Verwendung eines Schmelzweiterleitermaterials mit starken positiven Temperaturkoeffizienten sind die Verluste bei Normalbetrieb klein, während bei einem hohen Strom (Überstrom) infolge eines Fehlers in einem der beiden Gleichspannungs-Teilnetze dieser zu einem großen und leicht detektierbaren Spannungsabfall über der Schmelzsicherung 8 führt. Hierdurch kann die Betriebssicherheit verbessert werden.

Da die Schmelzsicherung 8 auch eine temperaturbestimmte Widerstandsänderung aufweist, wird der vorab bestimmte Grenzwert derart gewählt, dass bei Umgebungsbedingungen mit hohen Temperaturen kein unbeabsichtigtes Überschreiten des Spannungsgrenzwertes erfolgt.

Die in Fig. 1 gezeigte Ausgestaltungsvariante weist, da das steuerbare Halbleiterschaltelement 5 über keine interne Strom- oder Spannungserfassungseinheit zu verfügen braucht, einen einfachen Aufbau auf. Hierdurch kann die Schutzeinrichtung 1 mit geringen Kosten und geringem Bauraum bereitgestellt werden.

Ein besonderer Vorteil besteht darin, dass die ohnehin vorhandene Schmelzsicherung 8 dazu genutzt wird, den infolge eines Stromflusses sich ergebenden Spannungsabfall einer Auswerteeinheit 7 zuzuführen und zur Erzeugung eines Triggersignals zum Ansteuern des steuerbaren Halbleiterschaltelements zu nutzen.

Das gemäß Fig. 2 gezeigte Ausgestaltungsbeispiel umfasst zusätzlich zu den im Ausführungsbeispiel gemäß Fig. 1 genannten Elementen einen Shunt 9 als Messwiderstand. Der Shunt 9 ist in Reihe zu dem steuerbaren Halbleiterschaltelement 5 und der Schmelzsicherung 8 angeordnet, wobei der Shunt bevorzugt zwischen den beiden genannten Elementen liegt. Dadurch kann ein herkömmliches steuerbares Halbleiterschaltelement 5 mit integrierter Stromerfassung genutzt werden.

In herkömmlicher Weise erfolgt zusätzlich die Erfassung eines Spannungsabfalls U₉ über dem Shunt 9, wobei der Spannungsabfall wiederum durch die Auswerteeinheit 7 erfasst wird. Aus dem Spannungsabfall U₉ über dem Shunt 9 kann der durch die Leitung 4 fließende Strom I₄ ermittelt werden, da der Widerstandswert des Shunts 9 bekannt ist. Basierend auf dem Strom I₄ und dem Spannungsabfall U₈ über der Schmelzsicherung 8 kann dann ein Vitalparameter der Schmelzsicherung ermittelt werden. Dieser Vitalparameter ermöglicht die Erkennung der Alterung der Schmelzsicherung 8 durch einen Vergleich der Spannungsabfälle U₈, U₉ über der Schmelzsicherung 8 und dem Shunt 9, wodurch eine prädiktive Wartung der Schutzeinrichtung 1 ermöglicht wird. Der Anwender wird über den Anwendungszustand der Schmelzsicherung informiert und in die Lage versetzt, die Schmelzsicherung vor Eintritt eines Schadenfalles auszutauschen.

Der Vitalparameter kann beispielsweise dadurch bestimmt werden, dass aus dem Strom I₄ und einem initialen Widerstandswert der Schmelzsicherung ein theoretischer Spannungsabfall über der Schmelzsicherung 8 ermittelt wird und ein Vergleich des theoretischen Spannungsabfalls mit dem gemessen Spannungsabfall U₈ über der Schmelzsicherung 8 bestimmt wird. Weichen die beiden ermittelten Spannungsabfälle in vorgegebener Weise voneinander ab, kann auf eine fortgeschrittene Alterung der Schmelzsicherung 8 geschlossen werden.

Alternativ kann aus dem Strom und dem gemessen Spannungsabfall U₈ ein Widerstandswert der Schmelzsicherung 8 ermittelt werden und ein Vergleich des ermittelten Widerstandswerts mit einem für den gemessenen Strom I₄ vorab bestimmten initialen Widerstandswert bestimmt werden. Falls der Widerstandswert über der Schmelzsicherung im Laufe der Zeit (überproportional) ansteigt, ist dies ein Indikator für fortgeschrittene Alterung. Hierzu kann beispielsweise ein Schwellwertvergleich vorgenommen werden.

Die Auswertung bzw. Ermittlung des Vitalparameters erfolgt durch die Auswerteeinheit 7. Wird durch die Auswerteeinheit 7 bestimmt, dass eine fortgeschrittene Alterung der Schmelzsicherung 8 vorliegt, so kann ein Warnsignal generiert und an einem nicht näher dargestellten Ausgang der Auswerteeinheit 7 ausgegeben werden. Dieses kann beispielsweise an ein cloudbasiertes System übertragen werden.

Das gleichzeitige Vorsehen einer Schmelzsicherung 8 und eines Shunts 9 ermöglicht darüber hinaus ein redundantes Erzeugen des Triggersignals s_{Tr}.

## Patentansprüche

1. Schutzeinrichtung (1) zum Abschalten eines Überstroms in einem Gleichspannungsnetz, umfassend:
- ein steuerbares Halbleiterschaltelement (5) und eine Schmelzsicherung (8), die in einer zu überwachenden Leitung in Reihe miteinander verschaltet sind;
- eine Treiberschaltung (6), die beim Erhalt eines Triggersignals (s_{Tr}) das steuerbare Halbleiterschaltelement (5) sperrend schaltet;
- eine Auswerteeinheit (7) zur Erzeugung des Triggersignals (s_{Tr}), wobei die Auswerteeinheit (7) dazu eingerichtet ist, einen Spannungsabfall (U₈) über der Schmelzsicherung (8) zu ermitteln und basierend auf einem Ergebnis einer Auswertung des Spannungsabfalls (U₈) das Triggersignal (s_{Tr}) zu erzeugen.

2. Schutzeinrichtung nach Anspruch 1, **dadurch gekennzeichnet, dass** die Auswerteeinheit (7) dazu eingerichtet ist, den ermittelten Spannungsabfall (U₈) mit einem vorgegebenen Spannungsgrenzwert zu vergleichen und beim Überschreiten des Grenzwerts das Triggersignal zu erzeugen.

3. Schutzeinrichtung nach einem der vorhergehenden Ansprüche, **dadurch gekennzeichnet, dass** in der zu überwachenden Leitung zusätzlich ein Shunt (9) angeordnet ist, der in Reihe zu dem steuerbaren Halbleiterschaltelement (5) und der Schmelzsicherung (8) liegt.

4. Schutzeinrichtung nach Anspruch 3, **dadurch gekennzeichnet, dass** der Shunt (9) zwischen dem steuerbaren Halbleiterschaltelement (5) und der Schmelzsicherung (8) angeordnet ist.

5. Schutzeinrichtung nach Anspruch 3 oder 4, **dadurch gekennzeichnet, dass** die Auswerteeinheit (7) dazu eingerichtet ist, einen Spannungsabfall (U₉) über dem Shunt (9) zu ermitteln.

6. Schutzeinrichtung nach einem der Ansprüche 3 bis 5, **dadurch gekennzeichnet, dass** die Auswerteeinheit (7) dazu eingerichtet ist, aus dem Spannungsabfall (U₉) über dem Shunt (9) den durch die Leitung fließenden Strom (I₄) zu ermitteln und basierend auf dem Strom (I₄) und dem Spannungsabfall (U₈) über der Schmelzsicherung (8) einen Vitalparameter der Schmelzsicherung (8) zu ermitteln.

7. Schutzeinrichtung nach Anspruch 6, **dadurch gekennzeichnet, dass** die Auswerteeinheit (7) dazu eingerichtet ist, aus dem Strom (I₄) und einem initialen Widerstandswert der Schmelzsicherung (8) einen theoretischen Spannungsabfall (U₈') über der Schmelzsicherung zu ermitteln und aus einem Vergleich des theoretischen Spannungsabfalls (U₈') mit dem gemessenen Spannungsabfall (U₈) den Vitalparameter zu bestimmen.

8. Schutzeinrichtung nach Anspruch 6 oder 7, **dadurch gekennzeichnet, dass** die Auswerteeinheit (7) dazu eingerichtet ist, aus dem Strom (I₄) und dem gemessenen Spannungsabfall (U₈) einen Widerstandswert der Schmelzsicherung (8) zu ermitteln und aus einem Vergleich des ermittelten Widerstandswerts mit einem für den gemessenen Strom (I₄) vorab bestimmten initialen Widerstandswert den Vitalparameter zu bestimmen.
